# EUROPEAN PATENT SPECIFICATION

(11) **EP 3 347 541 B1**
(45) Date of publication and mention of the grant of the patent: **11.05.2022**
(21) Application number: 16834229.3
(22) Date of filing: 12.08.2016
(51) Int. Cl.: E04D 13/18, E04D 13/14, E04G 21/32, F24S 25/61, H02S 20/23

(54) **FIXTURE SYSTEM FOR MOUNTING ON ROOFS AND USE OF SUCH FIXTURE SYSTEM**
BEFESTIGUNGSSYSTEM ZUR MONTAGE AUF DÄCHERN UND VERWENDUNG SOLCH EINES BEFESTIGUNGSSYSTEMS
SYSTÈME DE FIXATION À MONTER SUR DES TOITS ET UTILISATION D'UN TEL SYSTÈME DE FIXATION

(30) Priority: 08.09.2015 DK 201570580
(43) Date of publication of application: 18.07.2018
(73) Proprietor: MUL10 Metal A/S, 7130 Juelsminde (DK)
(72) Inventor: HEDEVANG, Steen Preutun, 7130 Juelsminde (DK)
(74) Representative: Patrade A/S
(86) International application number: PCT/DK2016/050271
(87) International publication number: WO 2017/041805

(56) References cited:
- EP-A1- 2 687 267
- WO-A1-2012/163570
- DE-A1-102007 053 556
- DE-A1-102007 053 556
- DE-A1-102010 036 305
- DE-U1- 29 820 579
- DE-U1-202006 008 867
- DE-U1-202009 015 787
- FR-A1- 2 937 353
- JP-A- 2005 220 658
- JP-A- 2008 014 038
- JP-B2- 5 394 308
- NL-C2- 2 008 114
- US-A- 3 880 405
- US-A1- 2014 224 579
- ANONYMOUS: "MUL10 Konsol", PATENTRET MONTAGESYSTEM, 1 December 2014 (2014-12-01), XP055528416,

## Description

### Field of the Invention

The present invention concerns a fixture system for mounting on roofing felt or membrane roofs and of the type including at least one base for mounting on a roof surface, the roof including a support plate for a roofing felt cover or membrane, an underlying insulation and a supporting roof construction, wherein the base is integrated with a roofing felt or film flashing, the roofing felt or film flashing preferably including a lower roofing felt and a upper roofing felt for attachment to the roofing felt cover or membrane of the roof, the base including an abutment plate for fastening to the roof surface and a first anchoring rod projecting up from the top side of the abutment plate, wherein the anchoring rod is mounted in a bushing in the abutment plate and connected with anchoring means that are designed in dependence of the intended use.

### Background of the Invention

Various fixture systems for use on roofing felt or membrane roofs are known. Thus it is known with systems that are used in mounting solar cell systems, terraces, ventilation equipment and the like on a roof plate. Furthermore, it is known with security systems used for fall protection of persons that have to stay on roofs. There are legal requirements meaning that fall protection is to be established for work on roofs. Fall protections will typically include eyelets or wires fastened on the roof surface. Persons may attach themselves to these eyelets or wires via harnesses carried by the user, and which via straps are connected with the eyelets and/or the wires.

In order to establish mounting fittings it is therefore necessary first to establish fall protection systems for the subsequent mounting work. There may exist all kinds of work with requirements for fall protection. It is a work-intensive procedure to establish a safety system and then to mount a mounting system.

Moreover, the mounting of the required safety equipment is subject to strict limitations depending on the roof construction at which it is mounted. The requirements for such fall protection systems are described in the standard DS/EN795.

In testing the anchoring points are to resist fall load as well as static load.

When mounting the fixture system in roof surfaces with so-called hot roof there are special designs. Such a roof will normally consist of a roofing felt cover or membrane provided on a support plate. Under this support plate there is an insulation layer with greater or lesser thickness. A vapour barrier will be provided under the insulation, and under the vapour barrier a firm supporting building construction is provided.

Today, anchoring points in the form of a base with a support plate with an upwardly projection anchoring rod are used. This abutment plate establishes a connection by screwing the abutment plate onto the support plate of the roof. This is effected by screwing screws through holes at the corners of the abutment plate. Moreover, this base is fastened to the roof via a roofing felt cover or membrane which is heat melted onto the roofing felt cover or membrane.

In practice, it has appeared to be difficult for these bases to meet the conditions for fall protection. When the bases are loaded, this occurs by a lateral pull on the upwardly projecting anchoring rod in direction largely in parallel with the surface of the roof. By this loading it appears that the abutment plate will be bent up from the base in a way which is not acceptable according to current specifications.

In order to remedy this issue, it has been necessary to use very large abutment plates. However, this causes a problem with the sealing established by the roofing felt cover or membrane that is heat melted onto the roofing felt cover or membrane of the roof. Furthermore, these known bases are disadvantageous since they cannot absorb a vertical load in the form of compression or pull. The vertical compression will be very limited as it is to be absorbed in the support plate disposed under the roofing felt cover or membrane of the roof. By large loads there will be a risk of deflection. Also, a strong storm may give rise to pulls which are also difficult to absorb in the support plate.

Furthermore, constructions by which a single rod is drilled down through the entire roof construction for mounting in a supporting roof construction have been suggested.

By such a penetration of the roof there is also established a penetration of the vapour barrier. Since there are rules prescribing that the vapour barrier is to be intact, such a construction will not provide a secure anchoring base.

JP 2005220658 A discloses a fixture system of the type described by introduction. This comprises a base for mounting on the roof surface. The base is made with an integrated film flashing and includes an abutment plate for fastening on the roof surface as well as an anchoring rod mounted in a bushing and projecting upwards from the top side of the abutment plate. In this document there is no description of a second anchoring rod used for fastening in supporting roof construction and which is mounted in a reinforcing tube in order to enable preloading of such a second anchoring rod.

Other fixture systems are known for instance from JP 5394308 B2, DE 202009015787 U1, DE 102010036305 A1, while fall protection systems are known i.a. from US 2014/224579 A1 and NL 2008114 A.

### Object of the Invention

It is the purpose of the present invention to indicate a fixture system of the kind mentioned in the introduction and which enables relieving the drawbacks by the prior art roofing systems, hereby providing a fixture system that is easy and rapid to mount and which at the same time provides efficient fall protection. Moreover, it is an object to indicate a fixture system that also can be used for mounting equipment to be located above the roof. It is thus an object that the bases placed on the roof can be used for a fall protection system as well as a mounting system.

According to a further aspect, it is the object to indicate a fixture system that enables sealing of the vapour barrier when the latter is penetrated for fastening the base to a supporting roof construction under the vapour barrier.

### Description of the Invention

According to the present invention, this is achieved by a fixture system according to claim 1, which is peculiar in that a second anchoring rod also is mounted in a bushing in the abutment plate, projecting down from the bottom side of the abutment plate and provided with fastening means such that the second anchoring rod can be fastened in the supporting roof construction under the roof surface.

The invention furthermore concerns a use of a fixture system according to the invention for a combined fall protection system and mounting system. The number of penetrations of the roof compared with two separate systems is hereby reduced.

By the system according to the invention it is possible to establish a fastening to the supporting fixed building construction located under the roof and the insulation. Hereby is established a fixed anchoring of the base in the supporting roof construction, as for example a metal structure, a concrete structure or a wood structure.

The abutment plate is dimensioned so that it will not be bent up from the base. It is thus possible to vary the thickness or shape of the abutment plate. By a lateral pull a displacing movement will therefore arise in parallel with the roof surface. This is prevented due to interaction between the second anchoring rod and the integrated roofing felt or film flashing which is welded onto the roofing felt cover or membrane of the roof.

Very large displacing forces are thus to be produced in order for the abutment plate to be bent or displaced.

By applying the second anchoring rod extending through the roof and by fastening it to the supporting roof construction, a strong mounting point is established which can absorb vertical loads in the form of pull or compression, and which can be used for mounting equipment to be located above the roof surface. The load applied on the anchoring means on the first anchoring rod will therefore be transmitted securely to the supporting roof construction. The supporting construction is sometimes also termed the load-bearing construction.

According to a further embodiment, the fixture system according to the invention is furthermore peculiar in that a reinforcing tube that is shorter than the second anchoring rod is provided around the second anchoring rod.

Using a reinforcing tube around the second anchoring rod will enable that the abutment plate can be clamped against the reinforcing tube which is shorter than the anchoring rod. Hereby is achieved a particularly stable and rigid construction. The abutment plate can advantageously be clamped such that a preloading occurs in the anchoring rod. The design with the anchoring rod placed inside a reinforcing tube will provide greater bending resistance than a design only using an anchoring rod. Furthermore, the reinforcing tube may surround a hole provided in the vapour barrier for passage of the anchoring rod for fastening in the supporting construction located under the vapour barrier. Hereby is achieved certainty of a secure sealing of the vapour barrier at the point where the anchoring rod penetrates the former.

According to claim 1, the fixture system according to the invention is peculiar in that the abutment plate is provided with a three-dimensional structure. In an embodiment it is provided with projections on the top side of the abutment plate in order thereby to reinforce the bending resistance of the abutment plate.

As the abutment plate is provided a three-dimensional structure in the form of projections on the top side of the abutment plate, it is possible to increase the bending resistance compared with a plane abutment plate. The risk of it being bent up from the base is thereby reduced.

According to a further embodiment, the fixture system according to the invention is furthermore peculiar in that the second anchoring rod is provided with a screw thread interacting with a screw thread in the bushing of the abutment plate, and that the abutment plate is clamped down against the reinforcing tube such that there is a mechanical connection from the abutment plate to the fastening means, which are fastened in the supporting roof construction.

By this embodiment, the second anchoring rod can be mounted on the abutment plate in a simple way. Moreover, the clamping of the abutment plate against the reinforcing tube will establish a secure mechanical connection providing a bending-resisting design.

The fastening of the second anchoring rod is simply effected in that the bushing in the abutment plate is screwed until a firm connection is established to the second anchoring rod. The second anchoring rod only needs a screw thread at the end by which it is screwed to the bushing of the abutment plate.

The whole anchoring rod may alternatively be a threaded rod. By the mechanical connection from the abutment plate to the supporting roof construction there is certainty that pulling or compression in vertical direction will not have influence on the roof surface with the risk of leaks occurring in the roofing felt cover or membrane.

According to a further embodiment, the fixture system according to the invention is furthermore peculiar in that the projections are provided as radially oriented, elongated elevations that are pressed up or moulded parts of the abutment plate and provided in a number between 6 and 12, preferably 8.

By the three-dimensional form, the strength of the plate against bending is increased compared with a plane plate. According to the invention, the three-dimensional form is provided in radially oriented projections. These projections will extend from a central part of a rectangular plate and be directed towards the corners of the plate and the centre of the long sides of the plate. In this way preferably eight projections will be provided.

In practice, it has appeared that hereby is achieved sufficient strength against lateral pulling. In direction towards the corner of the plate there may be absorbed larger lateral pulling forces in parallel with the roof surface than attained when a pull is directed at right angles to the side edges of the plate. However, compensation can be made by not disposing the projections with equal angular spacing. Even if preferred that the angle is the same between all radial projections, it is also possible to vary this angle.

Tests used for approving the bases are based on the distance by which the abutment plate is bent up from the roof surface.

Experiments with abutment plates of 2 mm thickness, and which are square with a side length of 290 mm, show that by a lateral pull in the first anchoring rod with 100 kg in a common abutment plate and a reinforced abutment plate there is a distance between the side and the roof surface of 1 mm and 9 mm, respectively, by diagonal pulling, and of 3 and 10 mm, respectively, by pulling at right angles to the side of the abutment plate.

It is also possible, in an embodiment which is not claimed, to provide the plate with circular shape such that the same strength appears by pull in any direction.

The plate will preferably be a steel sheet of 2 mm stainless steel. The dimensions will typically be a square surface with a side length of 290 mm. However, the used plate may have greater or smaller dimensions, both with regard to the thickness and to the length of the side edges.

According to claim 1, the fixture system according to the invention is peculiar in that the anchoring means include a fitting at which can be mounted wires for a fall protection system.

As the anchoring means mounted on the upwardly projecting first anchoring rod includes a fitting at which wires can be mounted, an efficient fall protection can be established. The fitting can be provided as a fitting with an eyelet at which can be mounted a wire that fastens the user directly to the anchoring system.

The eyelet may alternatively be used for a through-going wire also passing through corresponding eyelets or fittings of other bases forming part of the fixture system. It is hereby possible to make a fixture system covering a desired area of a roof, and where a user can attach himself to a wire running between different bases that are fastened upon the roof.

According to a further embodiment, the fixture system according to the invention is furthermore peculiar in that the anchoring means include a support holder which is adapted for mounting equipment to be disposed above the roofing felt cover or membrane, as for example solar panels, terraces, railings, piping, air conditioning units.

If the anchoring means on the first anchoring rod includes a support holder for mounting, it is possible to mount various equipment to be located above the 2. roofing felt cover or membrane.

The applied support holder may be a support holder forming part of mounting systems known per se for railings, solar panels, piping, air conditioning units and the like. As the fixture system provides a fixed mechanical connection to the supporting roof construction, such elements can have considerable weight and can also be exposed to substantial wind pressure without risking that the roofing felt cover or membrane of the roof is destroyed.

According to a further embodiment, the fixture system according to the invention is furthermore peculiar in that the fastening means at the second anchoring rod includes a washer intended for bearing against a top side of the supporting roof construction.

By placing a washer on the second anchoring rod, this washer may be clamped onto a top side of the supporting roof construction. Since a vapour barrier is placed immediately upon the supporting roof construction, the washer can form a sealing of the opening at which second anchoring rod penetrates the vapour barrier in a particularly safe way.

The washer can be clamped against the supporting roof construction, e.g. by screwing it down into the supporting roof construction in the form of a concrete structure or wood structure.

According to a further embodiment, the fixture system according to the invention is furthermore peculiar in that the fastening means at the second anchoring rod includes a tilt anchor intended for bearing against a bottom side of the supporting roof construction. By using a tilt anchor bearing against the bottom side of the supporting roof construction the reinforcing tube can be clamped down against the top side of a plate or sheet against which tilt anchor is bearing on the bottom side. Thus there may be provided a clamping of a plate in a supporting roof construction which e.g. can be a trapezoidal profiled steel sheet or a wood plate. The tilt anchor will be clamped against the bottom side of the steel sheet while the reinforcing tube is clamped down against the top side of the sheet.

In addition it is preferred to use a washer which is brought to bear against the top side. However, in both cases there will be achieved a firm mechanical connection with the supporting roof construction, and at the same time there is achieved a secure closing of the opening in the vapour barrier.

According to a further embodiment, the fixture system according to the invention is furthermore peculiar in that the fixture system includes a number of feet for mounting on the roof surface, and that these feet are interconnected with wires and a rail system for establishing a combined fall protection system and mounting system covering a desired area of the roof surface.

By applying a plurality of bases on the roof surface and interconnecting these with wire and rail systems, it is possible to combine fall protection system and mounting system for covering a desired area of the roof surface.

It is possible that the anchoring means on the first anchoring rods both include support holders for mounting and fittings for the fall protection systems. But in such a situation it will only be necessary to provide one anchoring system on the roof. This will of course appreciably facilitate the procedure when equipment is to the mounted on a roof.

According to a further embodiment, the fixture system according to the invention is furthermore peculiar in that the abutment plate is a stainless, acid-proof steel sheet with a thickness between 1.5 mm and 4 mm, preferably 2 mm. It is preferred that the projections are formed by pressing the steel sheet.

The thickness of the steel sheet may vary, but in practice it appears that a 2 mm thick steel sheet, which is reinforced, will meet the requirements set up for fall protection. Such a sheet will typically be a square sheet with a side length between 250 and 350 mm, preferably 290 mm.

### Description of the Drawing

In the following, the invention will be explained in more detail with reference to the enclosed drawings, where:
- Fig. 1: shows a partial perspective view of a base for a fixture system according to the invention;
- Fig. 2: shows a partial section through a part of the base shown in Fig. 1;
- Fig. 3: shows a various views of an abutment plate forming part of the base shown in Fig. 1;
- Fig. 4: shows a sectional view through a detail with a further embodiment of a base for a fixture system according to the invention;
- Figs. 5-6: are cross-sectional views corresponding to Fig. 4 of further embodiments for a base for use in a fixture system according to the invention;
- Fig. 7: shows a partial sectional view of details of the second anchoring rod and the reinforcing tube;
- Figs. 8-14: show views of different steps by mounting a base as illustrated in Fig. 4;
- Figs. 15-20: show views of mounting a base as illustrated in Fig. 5;
- Figs. 21-26: show views of different embodiments of anchoring means for use on a base of a system according to the invention;
- Figs. 27-28: show views of various embodiments for a slide fitting for use in a fixture system according to the invention; and
- Figs. 29-34: show different examples of a fixture system according to the invention used for fall protection and for mounting equipment on a roof.

### Detailed Description of Embodiments of the Invention

In the following, identical or corresponding elements will be designated with the same reference numerals. No specific explanation will thus be given in connection with such details in connection with each Figure of the drawing.

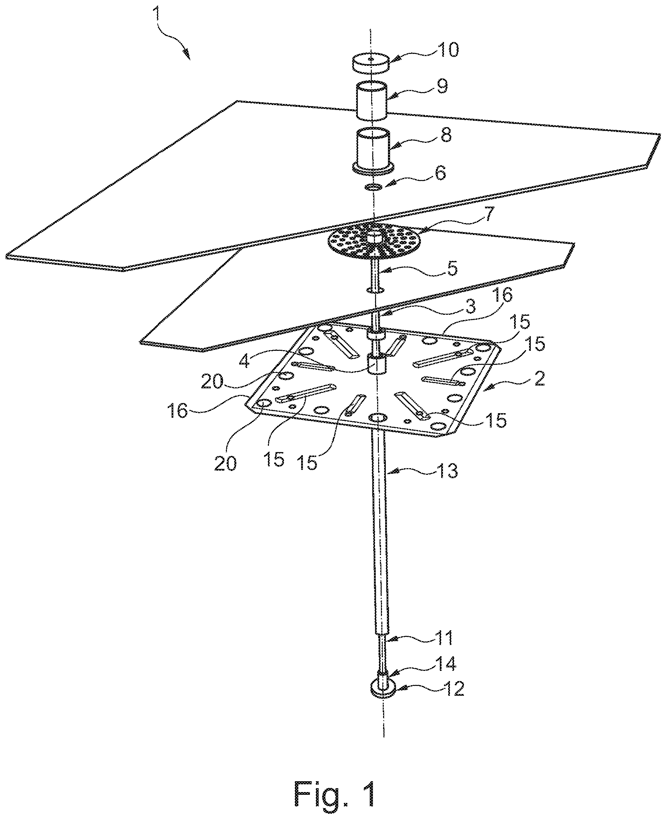

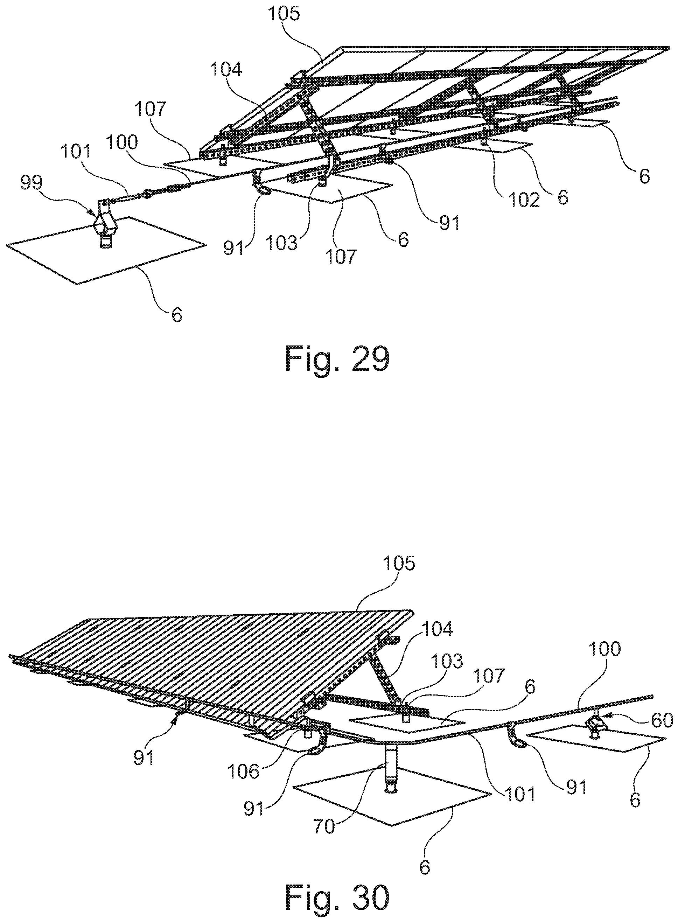

Fig. 1 shows a base 1 in a fixture system as illustrated in Figs. 29-34.

The anchoring base includes an abutment plate 2 and a first anchoring rod 3 protruding up from the abutment plate. The anchoring rod 3 is fastened to the abutment plate via a bushing 4 as the rod 3 is provided with a screw thread interacting with a screw thread in the bushing 4.

The base further includes a layer of lower roofing felt 5 and a layer of upper roofing felt 6. Between the two roofing felt layers 5, 6 there is welded a metal sheet 7 in the upper roofing felt for increasing durability.

Above the upper roofing felt 6 there is disposed a steel tube 8 and a self-adhesive fluid sealing.

At the top of the construction, an aluminium closure 10 is provided.

When the elements are mounted on the first anchoring rod 3, an outer threaded end will project over the aluminium closure 10. The threaded end can then be used for fastening anchoring means as will be explained in more detail below.

At the bottom side of the abutment plate 2 there is fastened a second anchoring rod 11 via a bushing (not shown). This is provided with fastening means which in the shown form is provided by means of a concrete screw 12. A reinforcing tube 13 is provided around the second anchoring rod 11. At the lower side of the reinforcing tube there is provided a washer 14 used for sealing against a vapour barrier.

The abutment plate 2 is a square plate or sheet provided with a three-dimensional structure as there is provided eight radially oriented projections 15. The projections are directed diagonally in relation to the plate and at right angles to the side edges 16 of the plate.

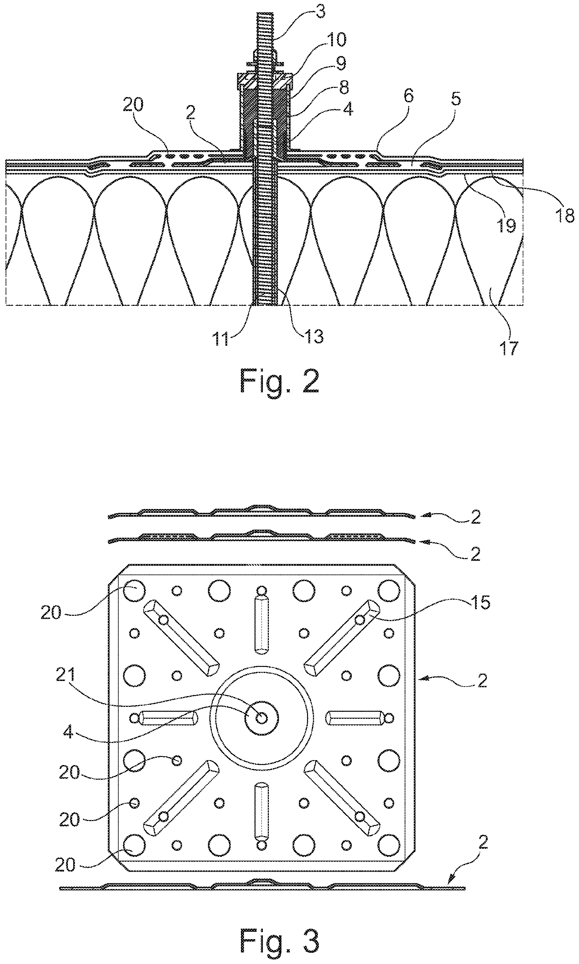

Fig. 2 is a cross-section through a part of the base shown in Fig. 1. In Fig. 2 appears an insulation 17 provided under a roofing felt cover or membrane 18 covering a roof surface. The roofing felt cover or membrane 18 is provided on a support plate 19. In Fig. 2 is illustrated how holes 20 in the abutment plate allows material from the different roofing felt or film layers to fuse and form a tight and strong fastening of the base on the roofing felt cover or membrane 18.

Fig. 3 illustrates how the abutment plate 2 is provided a spatial shape by providing pressed up projections 15. The holes 20 allowing material through-flow is also illustrated. In Fig. 3 is also seen how the bushing 4 has a central opening 21. This opening is provided with screw thread for receiving the threaded first anchoring rod.

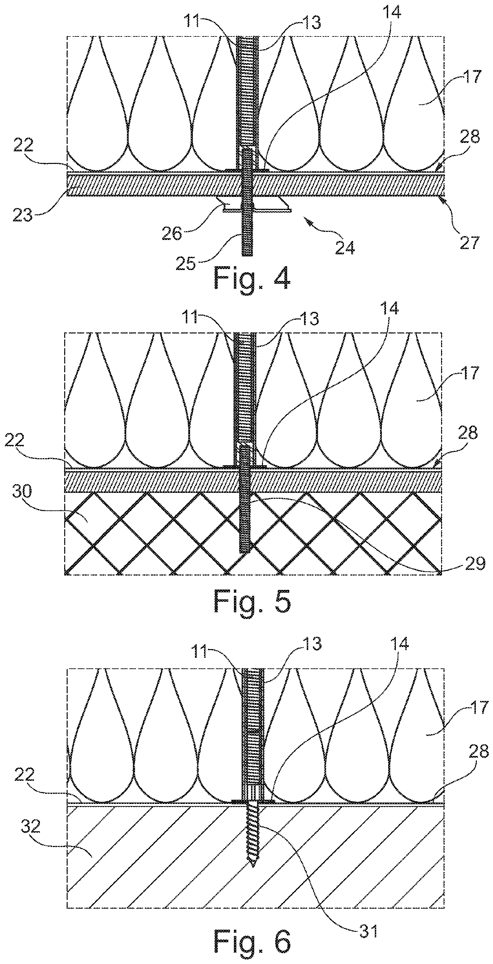

Fig. 4 illustrates a further embodiment of a base of a system according to the invention. This embodiment is intended for use in a hot roof with insulation 17 disposed upon a vapour barrier 22. The vapour barrier 22 rests on a plywood board 23 constituting the supporting construction for the hot roof.

By this embodiment, at the bottom of the second anchoring rod 11 there is mounted a tilt anchor 24. The tilt anchor 24 consists of a central rod 25 and a pivotably suspended anchor part 26. The anchor part 26 is shown in its position where it bears against a bottom side 27 of the plywood board 23. The washer 14 bears against the top side 28 of the plywood board as the vapour barrier 22 is clamped between the washer 14 and the plywood board such that sealing is provided when the tilt anchor is drawn to the shown position.

A metal sheet can be used as alternative to plywood.

In Fig. 5 is seen that the second anchoring rod is provided at its bottom side with a threaded concrete screw 29 which can be screwed into a supporting construction in the form of a concrete layer 30.

Fig. 6 is a further embodiment of a screw for use in the fixture system according to the invention. By this embodiment, at the lower end of the second anchoring rod 11 there is provided a wood screw 31 which is screwed into a supporting construction in the form of a wooden lath 32.

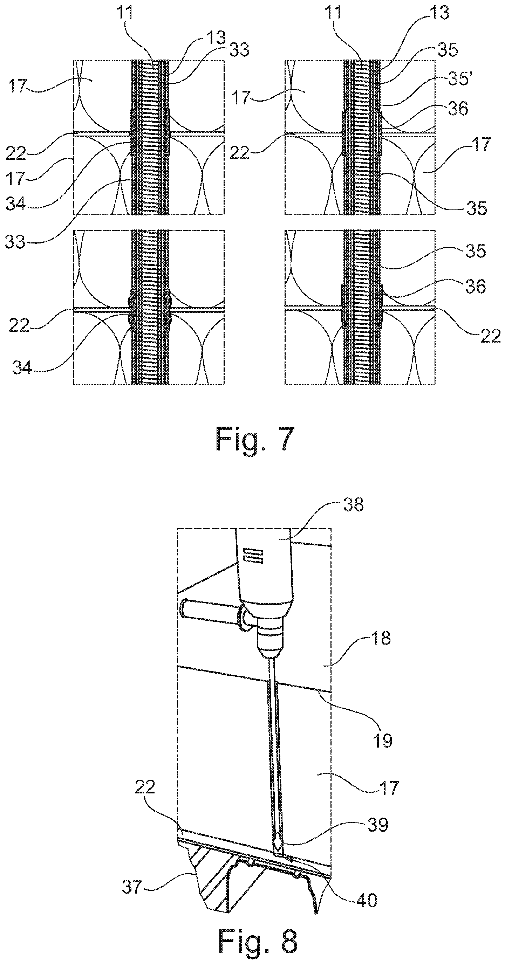

Fig. 7 shows two examples of a sealing against a vapour barrier 22 disposed between two insulations 17.

At the left side is seen how a further tube 33 is provided externally of the reinforcing tube 13. The tube 33 is provided in two separate lengths. Between these there is provided a deformable tube piece 34. As seen at the bottom left, the deformable tube piece 34 will be imparted deformation by clamping of the reinforcing tubes such that a sealing appears against the vapour barrier 22.

To the right is seen a further tube 35. This is also in two parts, and a deformation tube 36 is provided between the two tubes. The upper tube 35 is provided with an oblique bevelling 35' at its lower end. By assembling, the deformation tube 36 will therefore press outwards and seal against the vapour barrier 22 such as it appears in the lower right view in Fig. 7.

In connection with Figs. 8-14 it will be explained in the following how a base is mounted in a roof construction where the vapour barrier 22 and the insulation 17 rest on trapezoidal steel sheets 37.

As it appears on Fig. 8, by a drilling machine 38 provided with a stepped drill 39 there will be drilled through the roof membrane 18 and the support plate 19 and further on through the insulation and the membrane such that a hole 40 is formed through the vapour barrier 22 on the trapezoidal steel sheet 37.

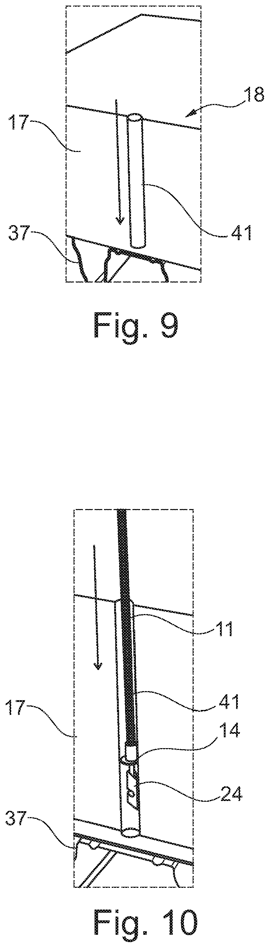

Fig. 9 shows that after drilling the hole a plastic tube 41 is pressed down into the boring. The length of the tube is adapted to the insulation thickness such that the top of the tube 41 is at level with the top side of the roofing felt cover 18.

As seen on Fig. 9 a second anchoring rod in the form of a threaded rod 11 is passed down through the tube 41 with a tilt anchor 24 mounted on the threaded rod 11, down through the plastic rod. The anchor is passed down through the hole 40 in the steel plate.

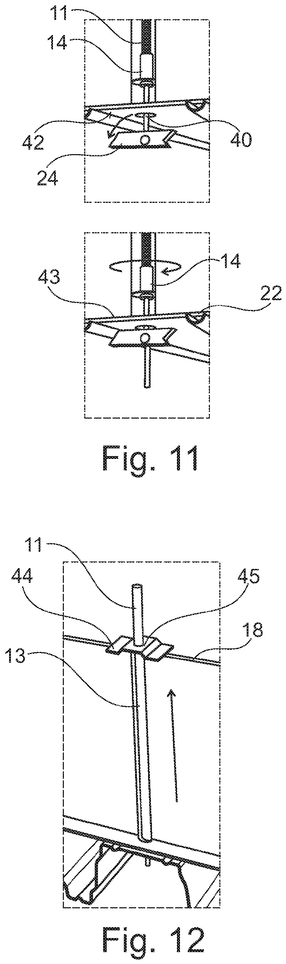

As it appears on Fig. 11, when disposed at the bottom side the tilt anchor 24 will pivot to the shown position, and then by an upwardly directed pull in the anchoring rod 11 establish contact of the tilt anchor 24 against the bottom side 42 of the trapezoidal steel plate 37.

By tightening the threaded anchoring rod 11 to the bottom as shown in the lower view on Fig. 11, the washer 14 will be clamped down against the top side 43 of the trapezoidal steel plate 37. The trapezoidal steel plate will hereby be clamped between the tilt anchor and the washer 14. The washer 14 will establish a clamping of the vapour barrier 22 such that safety against any leakage in the vapour barrier at the hole 40 is provided.

In Fig. 12 is seen that the reinforcing tube 13 is passed down around the anchoring rod 11. In Fig. 12 is seen a jig 44 applied for performing a marking 45 on the anchoring rod 11. This marking 45 is used for correct cutting off of the anchoring rod over the roofing felt cover 18.

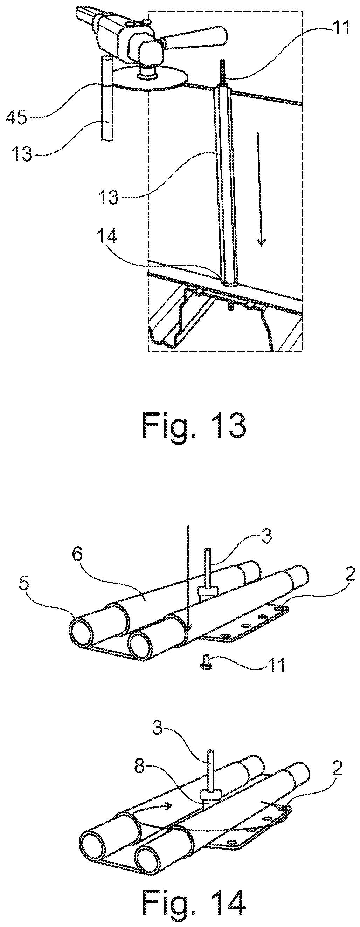

Fig. 13 illustrates that the anchoring tube 13 is shortened at the marking 45. The anchoring rod is then passed around the anchoring rod 11 to the shown position. The anchoring rod 13 is passed right down so as to be in contact with the washer.

Fig. 14 shows how the abutment plate 2 is passed down on the second anchoring rod 11. This occurs with the integratedly provided roofing felt layers 5, 6 mounted over the abutment plate 2.

As it appears at the bottom of the drawing in Fig. 14, the abutment plate 2 is screwed onto the second anchoring rod 11 with the first anchoring rod 3 projecting up from the top side of the abutment plate 2. There is hereby established a secure mechanical connection to the supporting roof construction via the tilt anchor and the washer to the first anchoring rod 3, after which desired anchoring means can be screwed on, depending on the intended use.

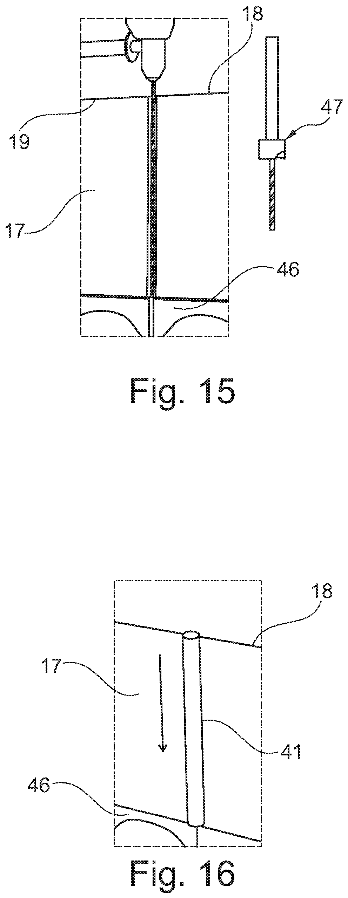

In Figs. 16-20 is illustrated mounting of a base in a supporting roof construction, which is a concrete panel 46. It appears that here is used a drill 47 with cutter and drill extender after drilling through the insulation thickness.

Fig. 16 corresponds to Fig. 9.

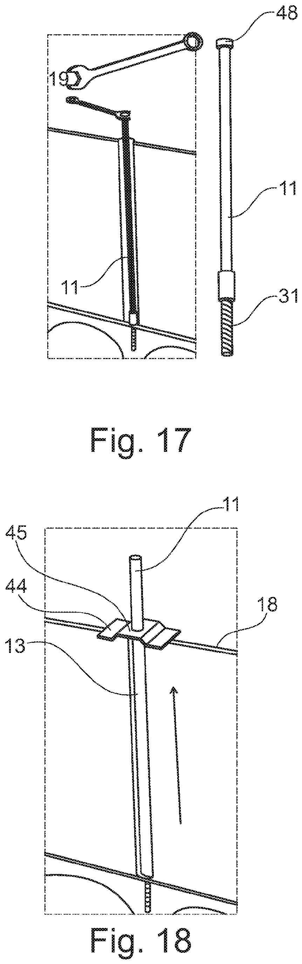

Fig. 17 shows that an anchoring rod 11 with pre-mounted concrete screw 31 is screwed down into the hole. Tightening is performed with a spanner by a box nut 48 mounted on the anchoring rod 11.

Fig. 18 shows a marking corresponding to the marking explained in connection with Fig. 12.

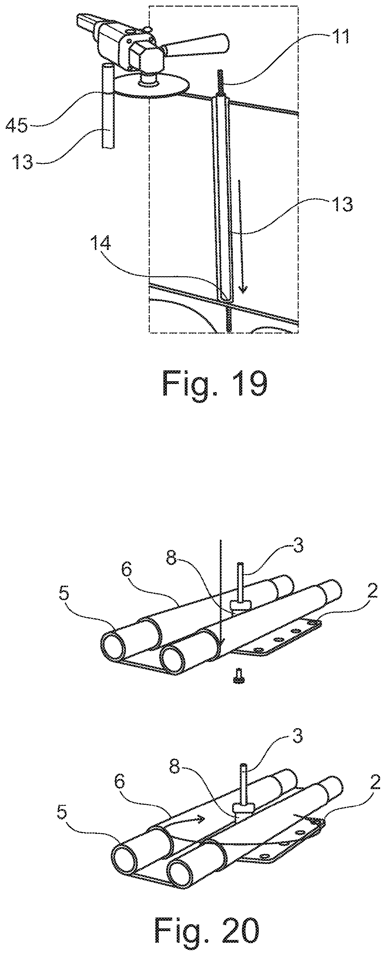

Fig. 19 shows a shortening corresponding to the shortening explained in connection with Fig. 13.

Fig. 20 shows mounting of the abutment plate 2 and the roofing felt 5, 6 corresponding to the one shown in Fig. 14.

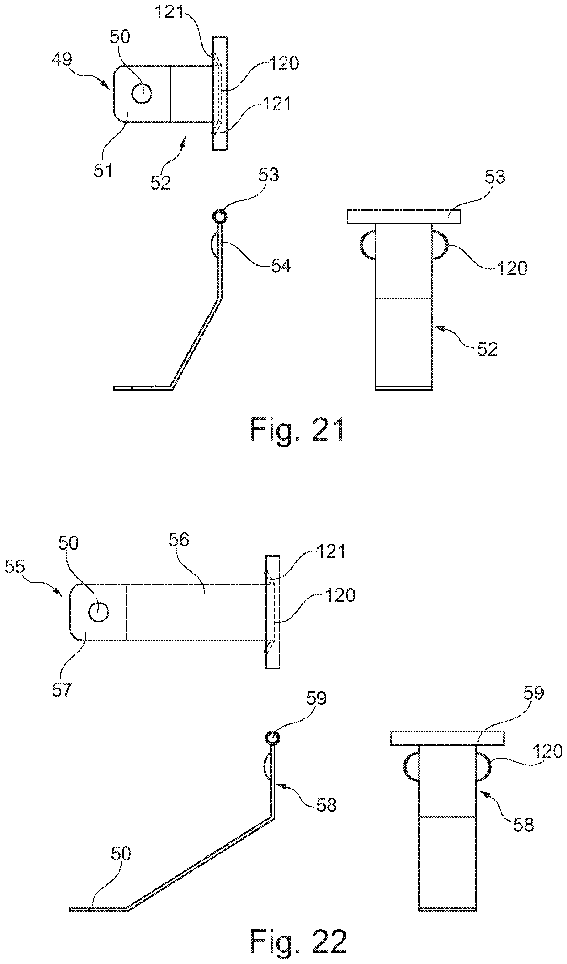

Figs. 21-26 show various embodiments of anchoring means intended for mounting on the first anchoring rod. In all these embodiments there is shown a bent plate. This plate can be reinforced by ribs or supplementing support plates.

As it appears on the preceding Figures, the first anchoring rod 3 will project over the steel tube 8 that is fastened over the abutment plate 2.

In Fig. 21 appears an embodiment of a first anchoring means 49 having an opening 50, a first plate part 51 of a bent plate 52. The opening 50 is provided for placing on the first anchoring rod 3 (not shown here). By the bent plate 51, at the outer end of a second plate part 54 there is provided a guide 53 for receiving a wire used in a fall protection system.

In this design, above the opening 50 there is a free area beside the second plate part 54 on which the guide 53 is provided. Therefore it will be possible that at the top of the first anchoring rod (not shown here) there is mounted a further anchoring means (not shown) in the form of a support holder for mounting equipment (see e.g. Figs. 29-34) to be disposed above the roofing felt cover or membrane.

The guide 53 is provided in the form of a rectilinear tube. This first anchoring means 49 will therefore be suited for use in a fixture system where several guides 53 are provided for the wire extending over a distance.

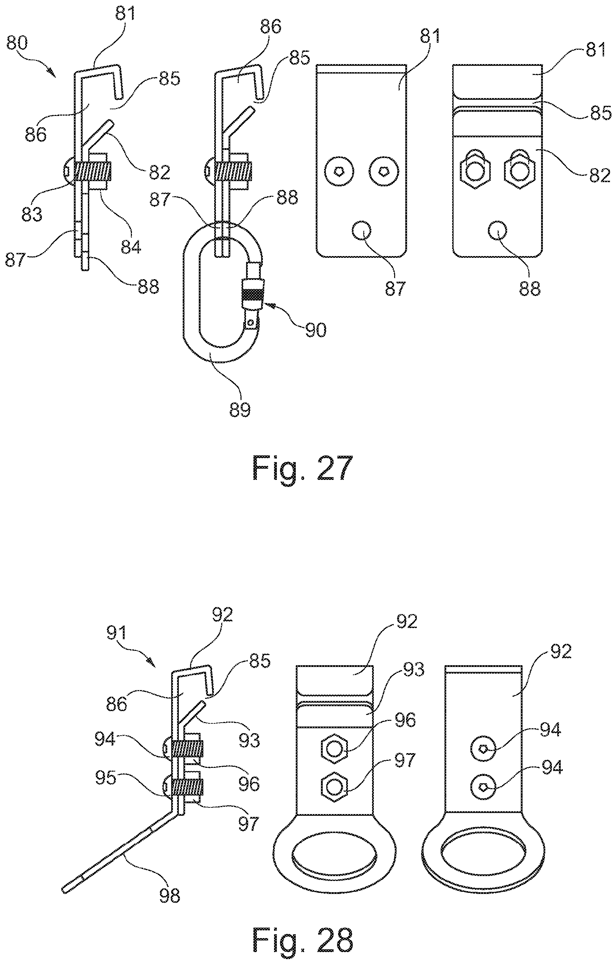

There is a guide plate 120 with angularly bent end parts 121 under the guides. This guide plate 120 provides a gradual transition for a slide (mentioned later in connection with Figs. 27 and 28), when it is to go from the wire and in over the guide 53. By means of the angularly bent end parts 121 of the guide plate, the slide is guided to the correct side of the anchoring means 49.

Fig. 22 shows an embodiment of a second anchoring means 55. This anchoring means 55 also includes a plate 56 in which the opening 50 is provided in a first plate part 57. In a second plate part 58, a guide 59 is provided at an outer end. This guide is also provided in the form of a rectilinear tube.

By this embodiment, the plate 56 is bent at a greater angle than shown in Fig. 21. Thus it will be possible that on a first anchoring rod 3 passing through the opening 50 there is provided a support holder having substantially greater width than the support holder capable of being placed in the embodiment shown in Fig. 21.

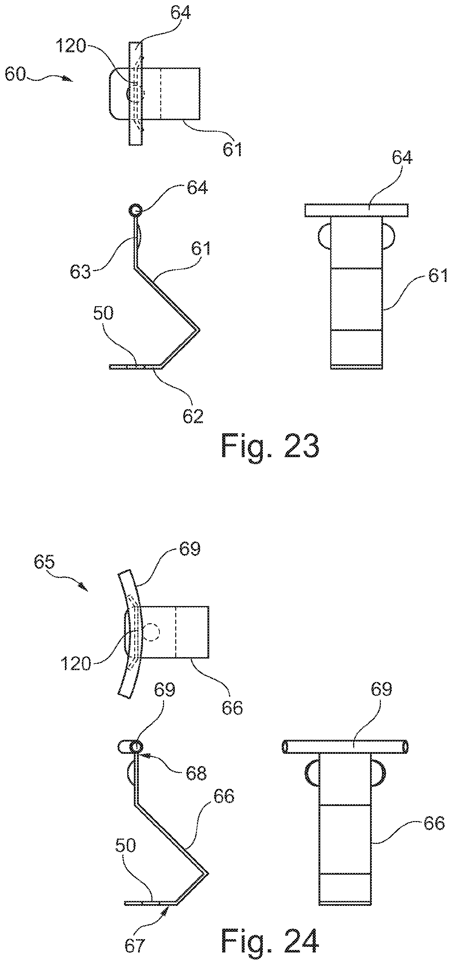

Fig. 23 shows an embodiment of a third anchoring means 60. This third anchoring means 60 includes a bent plate 61 which at a first plate part 62 is provided with the opening 50, and which at a second plate part 63 is provided with a guide 64 for receiving a wire. The guide 64 is also provided in a rectilinear tube that serves to receive the wire.

The plate 61 is bent such that the second plate part 63 is disposed in over the opening 50. The first anchoring rod 3 passing through the opening 50 will therefore not be particularly suited for use for other equipment to be provided above the roof surface. However, it is noted that a low mounting means can be provided within the interspace formed by the bent plate 61.

Fig. 24 shows an embodiment of a fourth anchoring means 65. This anchoring means 65 is also formed by a bent plate 66. The opening 50 is provided at a first plate part 67. A guide 69 is provided at the second plate part 68 of the plate 66. The guide 69 is provided in the form of a curving tube. The anchoring means 65 will therefore be used for establishing a change of direction for a wire passing through the guide 69.

The anchoring means 65 includes a plate 66 which is bent at largely the same angle as the plate 61 in Fig. 23. Therefore, in connection with this embodiment the same considerations will apply with regard to disposition of support holders for mounting on the first anchoring rod 3 passing through the opening 50.

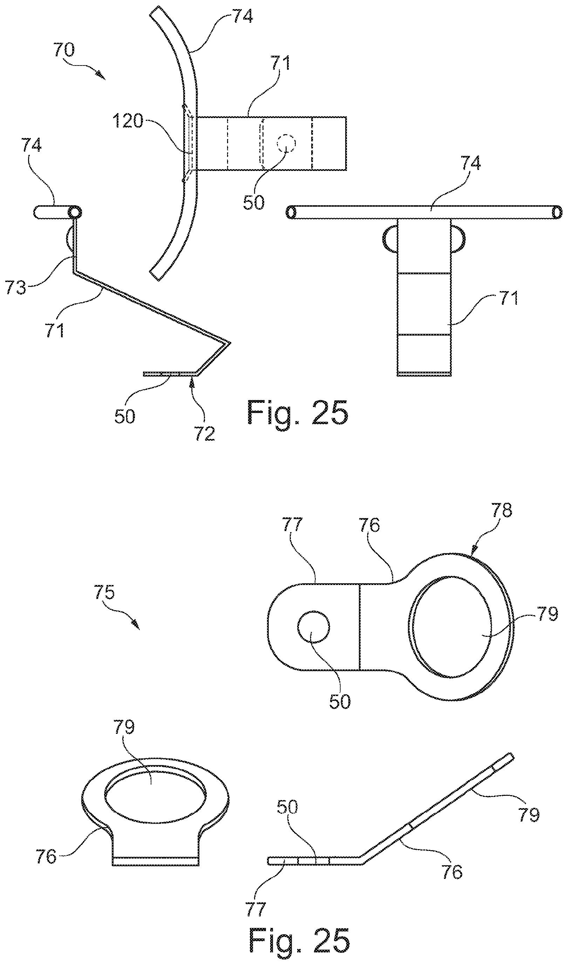

Fig. 25 shows an embodiment of a fifth anchoring means 70. The anchoring means 70 includes a plate 71. The opening 50 is provided at a first plate part 72. A guide 74 is provided at the second plate part 73. The guide 74 is also here a curving tube. By this angle is seen that the anchoring means 70 can be used for change of direction of a wire passing through the guide 74 such that it is imparted a directional change of approximately 90°.

There is an angular bending of the plate 71 in the anchoring means 70 such that the second plate part 73 largely covers the first anchoring rod 3 passing through the hole 50. Therefore, in this embodiment there will largely only be space for a nut or similar used for fastening the anchoring means 70.

Fig. 26 shows an embodiment of a sixth anchoring means 75. The anchoring means 75 includes a plate 76. The opening 50 is provided at a first plate part 77. An opening 79 is provided at the second plate part 78. The opening 79 can be used for fastening a snap hook or similar which is fastened to the strap of a safety harness for a user on the roof. Alternatively, the opening 79 can be used for passing a wire there through.

This embodiment is particularly simple. The second plate part 78 is bent away from the first plate part 77 such that there is free space above the opening for placing mounting means at the end of the first anchoring rod 3 passing through the opening 50.

Fig. 27 shows an embodiment of a first slide fitting 80 for use in a fixture system according to the invention. The slide fitting 80 includes a first plate part 81 that is assembled with a second plate part 82 via screws 83 and nuts 84. The two plate parts 81, 82 are angularly bent such that an opening 85 appears into an inner space 86 in which a wire can be received.

It appears in the outer left view that the two plate parts 81, 82 are offset such that the opening 85 appears with a large opening, allowing a wire to pass through the opening 85.

In the second view from the left is seen that the opening is reduced in that the two plate parts 81, 82 are displaced such that the opening 85 gets a size that a wire can no longer pass through the opening, and therefore remains in the space 86.

Openings 87 and 88, respectively, are provided in the two plate parts 81, 82. When the two plate parts 81, 82 are displaced to the position shown in the second view from left, the openings are aligned, and the two plate parts are retained in their mutual position in that a snap hook 89, which is provided with a slide lock 90, enables connecting the slide fitting 80 to a strap that is fastened to a safety harness on a user working on the roof.

Fig. 28 shows an embodiment of a second slide fitting 91. The slide fitting 91 is also formed by a first plate part 92 and a second plate part 93 providing the opening 85 and the cavity 86 for receiving a wire.

In this design, the two plate parts 92, 93 are assembled by means of two screws 94, 95, each interacting with a nut 96, 97. In this embodiment, the slide fitting 91 will be mounted at a position around a wire and then clamped. The opening 85 has such a size that the wire cannot pass out through the opening. The slide fitting in the plate part 92 is provided with an opening 98 serving to receive a snap hook or similar used for mounting a strap fastened to a safety harness on a user on the roof.

Fig. 29 shows a first embodiment of a fixture system according to the invention. In this system is applied a base 99 which is used for fastening a wire 100. The wire 100 is provided with a turnbuckle 101 such that it can be tightened to desired tension. A number of slide fittings 91 are provided on the wire 100. Alternatively, slide fittings 80 can be used.

Moreover, a number of bases 102 are provided, each provided with anchoring means for the wire 100 and at the same time supporting support holders 103 for a supporting structure 104 for solar cell panels 105. Solar cell panels are shown as an example. Alternatively, they may be roof terraces, ventilation equipment etc.

Fig. 30 shows a second embodiment of a fixture system according to the invention. Here it is seen how the wire 100 is passed around a corner via an anchoring means 70 as shown in Fig. 25. Furthermore is seen an anchoring means 60 of the type shown in Fig. 23.

Moreover, slide fittings 91 provided on the wire 100 are seen.

In this embodiment, solar cell panels 105 are mounted on mounting construction 104 which at one side is mounted on bases 106. Each base 106 supports an anchoring means 55 of the type illustrated in Fig. 22, thus allowing that above the first anchoring rod 3 there is a relatively large opening where the solar cell panel 105 may be provided. At the other side, the mounting construction 104 is mounted on bases 107 (also seen in Fig. 29). The bases 107 are only provided with anchoring means that include a support holder 103. In this design, the anchoring means may in principle only consist of the upwardly projecting part of the first anchoring rod 3.

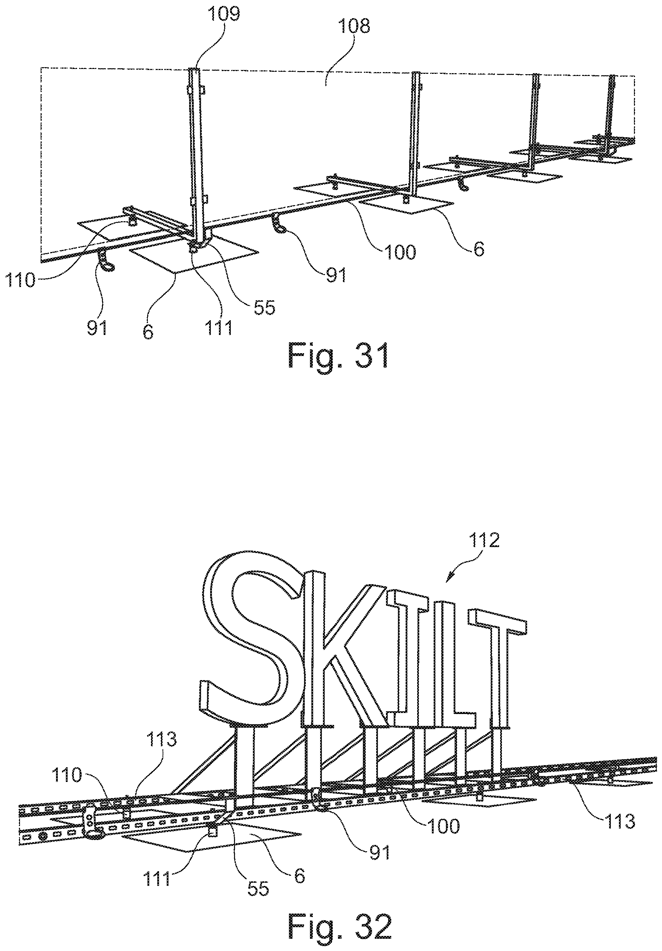

Fig. 31 shows an anchoring system that supports a railing 108. The railing 108 is disposed on angularly bent support holders 109 that rest on bases 110, 111. It appears that the bases 110 only serve to support the support holder, and that the base 111 is provided with an anchoring means 55 of the type shown in Fig. 22.

Fig. 32 shows an embodiment wherein a sign 112 is supported instead of a railing. The sign is supported by two mounting beams 113 placed on bases 110 and 111, respectively, as also explained in Fig. 31.

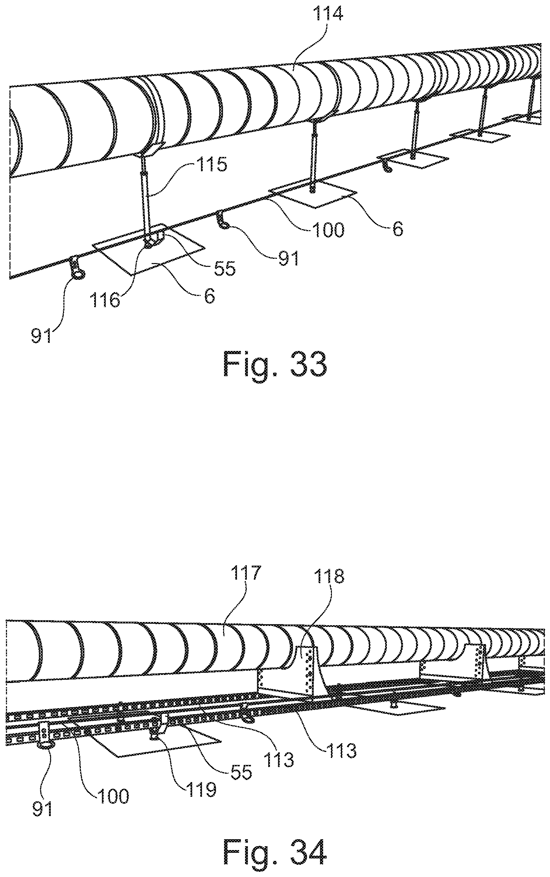

Fig. 33 shows a further embodiment of a fixture system where a pipeline 114 is supported. The pipeline 114 is mounted on support rods 115 placed on bases 116. The bases 116 are also connected with anchoring means 55 of the type illustrated in Fig. 22.

Fig. 34 shows an embodiment in which a heavy pipeline 117 is supported in support holders 118. The support holders 118 are mounted on two mounting beams 113. The mounting beams rest on bases 119. The bases 119 are provided with anchoring means 55 of the type illustrated in Fig. 22.

The invention is explained in connection with various embodiments, but deviations can be made from the above embodiments within the limits defined by the claims. It is also possible to combine different embodiments of the anchoring means with different designs of the bases, still within the limits defined by the claims.

As an example as to the dimensions, the following can be specified: The drill used for drilling through insulation and vapour barrier can have a diameter of 25 mm.

The plastic tube pressed down into the hole will have a diameter of 40 mm.

The second anchoring rod can be a threaded rod with a 12 mm screw thread. The anchoring tube 13 can be a 20 mm stainless tube.

The anchoring tube 30 will typically be cut off 10 mm above the roof surface.

The second anchoring rod 11 is shortened to a position 30 mm over the roof surface.

The first anchoring rod is provided above the roof surface and can, depending on the intended application, have different lengths. The first anchoring rod can typically have a height above the roof surface between 50 and 100 mm.

The abutment plate 2 will typically be a steel sheet with a thickness of 2 mm and be a square with a slide length of 290 mm.

The above dimension only serve as illustration of a single embodiment as dimensions that are greater or lesser may be applied.

## Claims

1. A combined fall protection and fixture system for mounting on roofing felt or film coated roofs and including at least one base (1) for mounting on a roof surface, the roof including a support plate (19) for a roofing felt cover or membrane (18), an underlying insulation (17) and a supporting roof construction (23), wherein the base (1) is integrated with a roofing felt or film flashing, the roofing felt or film flashing preferably including a lower roofing felt (5) and a upper roofing felt (6) for attachment to the roofing felt cover or membrane (18) of the roof, the base (1) including an abutment plate (2) for fastening to the roof surface and a first anchoring rod (3) projecting up from the top side of the abutment plate, wherein the abutment plate (2) is a rectangular plate having side edges, wherein the anchoring rod (3) is mounted in a bushing (4) in the abutment plate (2), and which anchoring rod (3) is connected with anchoring means (49, 55, 60, 65, 70, 75) that are designed in dependence of the intended use,
wherein the abutment plate (2) is provided with a three-dimensional form as it is provided with radially extending projections (15) extending from a central part of the rectangular plate and be directed towards the corners of the plate and the centre of the long sides of the plate, wherein
that the anchoring means include a fitting with an eyelet at which can be mounted a wire that fastens the user directly to the combined fall protection and fixture system or alternatively the eyelet may be used for a through-going wire (100) also passing through corresponding eyelets or fittings of other bases forming part of a combined fall protection and fixture system, wherein
a second anchoring rod (11) also is mounted in the bushing (4) in the abutment plate (2), projecting down from the bottom side of the abutment plate (2) and provided with fastening means (12, 24, 29, 31) such that the second anchoring rod (11) can be fastened in the supporting roof construction (23, 30, 32) under the roof surface.

2. A combined fall protection and fixture system according to claim 1, **characterised in that** a reinforcing tube (13) that is shorter than the second anchoring rod (11) is provided around the second anchoring rod (11).

3. A combined fall protection and fixture system according to claim 1 or 2, **characterised in that** the abutment plate (2) is provided with projections (15) from the top side of the abutment plate in order thereby to reinforce the bending resistance of the abutment plate.

4. A combined fall protection and fixture system according to claim 2 or claims 2 and 3, **characterised in that** the second anchoring rod (11) is provided with a screw thread interacting with a screw thread in the bushing (4) of the abutment plate, and that the abutment plate is clamped down against the reinforcing tube (13) such that there is a mechanical connection from the abutment plate (2) to the fastening means (12, 24, 29, 31), which are fastened in the supporting roof construction.

5. A combined fall protection and fixture system according to claim 3 or 4, **characterised in that** the projections (15) are provided as radially oriented, elongated elevations that are pressed up or moulded parts of the abutment plate (2) and provided in a number between 6 and 12, preferably 8.

6. A combined fall protection and fixture system according to any preceding claim, **characterised in that** the anchoring means (49, 55, 60, 65, 70, 75) include a support holder (103, 109) which is adapted for mounting equipment (105, 108, 114) to be disposed above the roofing felt cover or membrane (18), as for example solar panels, terraces, railings, piping, air conditioning units.

7. A combined fall protection and fixture system according to any preceding claim, **characterised in that** the fastening means at the second anchoring rod (11) includes a washer (14) intended for bearing against a top side (28, 43) of the supporting roof construction (23, 37).

8. A combined fall protection and fixture system according to claim 7, **characterised in that** the fastening means at the second anchoring rod (11) includes a tilting anchor (24) intended for bearing against a bottom side (27) of the supporting roof construction (23).

9. A combined fall protection and fixture system according to any preceding claim, **characterised in that** the fixture system includes a number of bases (1) for mounting on the roof surface, and that these bases are interconnected with wires (100) and a rail system (113) for establishing a combined fall protection system and mounting system covering a desired area of the roof surface.

10. A combined fall protection and fixture system according to any preceding claim, **characterised in that** the abutment plate (2) is a stainless acid-proof steel sheet with a thickness between 1.5 mm and 4 mm, preferably 2 mm.

11. A combined fall protection and fixture system according to any preceding claim 3 - 11, **characterised in that** the projections (15) are formed by pressing the steel sheet.

12. Use of a system according to any preceding claim for a combined fall protection system and mounting system.

13. Use of a fixture system including at least one base (1) for mounting on a roof surface, the base (1) including an abutment plate (2) for fastening to the roof surface and a first anchoring rod (3) projecting up from the top side of the abutment plate, wherein the anchoring rod (3) is mounted in a bushing (4) in the abutment plate (2) and connected with anchoring means (49, 55, 60, 65, 70, 75) that are designed in dependence of the intended use, wherein a second anchoring rod (11) also is mounted in a bushing (4) in the abutment plate (2), projecting down from the bottom side of the abutment plate and provided with fastening means (12, 24, 29, 31) such that the second anchoring rod (11) can be fastened in the supporting roof construction (23, 30, 32) under the roof surface wherein the fixture system is mounted on roofing felt or film coated roofs, the roof including a support plate (19) for a roofing felt cover or membrane (18), an underlying insulation (17) and a supporting roof construction (23), wherein the base (1) is integrated with a roofing felt or film flashing, the roofing felt or film flashing preferably including a lower roofing felt (5) and a upper roofing felt (6) for attachment to the roofing felt cover or membrane (18) of the roof, for a combined fall protection system and mounting system.

## Patentansprüche

1. Kombiniertes Absturzsicherungs- und Befestigungssystem zur Montage auf mit Dachpappe oder Dachfolie bedeckten Dächern, das mindestens eine Basis (1) zur Montage auf einer Dachfläche beinhaltet, wobei das Dach eine Stützplatte (19) für eine Dachpappenabdeckung oder -membran (18), eine darunter liegende Isolierung (17) und eine tragende Dachkonstruktion (23) beinhaltet, wobei die Basis (1) in einen Dachpappen- oder Dachfolienanschluss integriert ist, wobei der Dachpappen- oder Dachfolienanschluss vorzugsweise eine untere Dachpappe (5) und eine obere Dachpappe (6) zur Befestigung an der Dachpappenabdeckung oder -membran (18) des Daches beinhaltet, wobei die Basis (1) eine Anschlagplatte (2) zur Befestigung an der Dachfläche und eine erste Ankerstange (3) beinhaltet, die von der Oberseite der Anschlagplatte nach oben vorsteht, wobei die Anschlagplatte (2) eine rechteckige Platte mit Seitenkanten ist, wobei die Ankerstange (3) in einer Hülse (4) in der Anschlagplatte (2) montiert ist, und die Ankerstange (3) mit Ankermitteln (49, 55, 60, 65, 70, 75) verbunden ist, die in Abhängigkeit von dem Verwendungszweck ausgestaltet sind,
wobei die Anschlagplatte (2) mit einer dreidimensionalen Form versehen ist, da sie mit sich radial erstreckenden Vorsprüngen (15) versehen ist, die sich von einem mittleren Teil der rechteckigen Platte erstrecken und zu den Ecken der Platte und der Mitte der langen Seiten der Platte gerichtet sind, wobei die Ankermittel einen Beschlag mit einer Öse beinhalten, an der ein Kabel montiert werden kann, mit dem der Benutzer direkt an dem kombinierten Absturzsicherungs- und Befestigungssystem gesichert werden kann, oder alternativ kann die Öse für ein durchgehendes Kabel (100) verwendet werden, das auch durch entsprechende Ösen oder Beschläge anderer Basen, die einen Teil eines kombinierten Absturzsicherungs- und Befestigungssystems bilden, geführt wird, wobei eine zweite Ankerstange (11) ebenfalls in der Hülse (4) in der Anschlagplatte (2) montiert ist,
die von der Unterseite der Anschlagplatte (2) nach unten ragt und mit Befestigungsmitteln (12, 24, 29, 31) versehen ist, sodass die zweite Ankerstange (11) in der tragenden Dachkonstruktion (23, 30, 32) unter der Dachfläche befestigt werden kann.

2. Kombiniertes Absturzsicherungs- und Befestigungssystem nach Anspruch 1, **dadurch gekennzeichnet, dass** um die zweite Ankerstange (11) herum ein Verstärkungsrohr (13) bereitgestellt ist, das kürzer als die zweite Ankerstange (11) ist.

3. Kombiniertes Absturzsicherungs- und Befestigungssystem nach Anspruch 1 oder 2, **dadurch gekennzeichnet, dass** die Anschlagplatte (2) mit Vorsprüngen (15) ausgehend von der Oberseite der Anschlagplatte versehen ist, um dadurch die Biegefestigkeit der Anschlagplatte zu verstärken.

4. Kombiniertes Absturzsicherungs- und Befestigungssystem nach Anspruch 2 oder Anspruch 2 und 3, **dadurch gekennzeichnet, dass** die zweite Ankerstange (11) mit einem Gewinde versehen ist, das mit einem Gewinde in der Hülse (4) der Anschlagplatte zusammenwirkt, und dass die Anschlagplatte so gegen das Verstärkungsrohr (13) festgeklemmt ist, dass eine mechanische Verbindung von der Anschlagplatte (2) zu den Befestigungsmitteln (12, 24, 29, 31) besteht, die in der tragenden Dachkonstruktion befestigt sind.

5. Kombiniertes Absturzsicherungs- und Befestigungssystem nach Anspruch 3 oder 4, **dadurch gekennzeichnet, dass** die Vorsprünge (15) als radial ausgerichtete, langgestreckte Erhebungen bereitgestellt sind, die hochgepresste oder geformte Teile der Anschlagplatte (2) sind und in einer Anzahl zwischen 6 und 12, vorzugsweise 8, bereitgestellt sind.

6. Kombiniertes Absturzsicherungs- und Befestigungssystem nach einem der vorhergehenden Ansprüche, **dadurch gekennzeichnet, dass** die Ankermittel (49, 55, 60, 65, 70, 75) eine Stützhalterung (103, 109) beinhalten, die zur Montage von Ausrüstung (105, 108, 114) ausgelegt ist, die über der Dachpappenabdeckung oder - membran (18) anzuordnen ist, wie z. B. Solarzellenplatten, Terrassen, Geländer, Rohrleitungen, Klimaanlagen.

7. Kombiniertes Absturzsicherungs- und Befestigungssystem nach einem der vorhergehenden Ansprüche, **dadurch gekennzeichnet, dass** das Befestigungsmittel an der zweiten Ankerstange (11) eine Unterlegscheibe (14) beinhaltet, die dazu bestimmt ist, an einer Oberseite (28, 43) der tragenden Dachkonstruktion (23, 37) anzuliegen.

8. Kombiniertes Absturzsicherungs- und Befestigungssystem nach Anspruch 7, **dadurch gekennzeichnet, dass** das Befestigungsmittel an der zweiten Ankerstange (11) einen neigbaren Anker (24) beinhaltet, der dazu bestimmt ist, an einer Unterseite (27) der tragenden Dachkonstruktion (23) anzuliegen.

9. Kombiniertes Absturzsicherungs- und Befestigungssystem nach einem der vorhergehenden Ansprüche, **dadurch gekennzeichnet, dass** das Befestigungssystem eine Anzahl von Basen (1) zur Montage auf der Dachfläche beinhaltet, und dass diese Basen mit Kabeln (100) und einem Schienensystem (113) zum Herstellen eines kombinierten Absturzsicherungssystems und Befestigungssystems verbunden sind, das einen gewünschten Bereich der Dachfläche abdeckt.

10. Kombiniertes Absturzsicherungs- und Befestigungssystem nach einem der vorhergehenden Ansprüche, **dadurch gekennzeichnet, dass** die Anschlagplatte (2) ein Blech aus rostfreiem säurebeständigem Stahl mit einer Dicke zwischen 1,5 mm und 4 mm, vorzugsweise 2 mm, ist.

11. Kombiniertes Absturzsicherungs- und Befestigungssystem nach einem der vorhergehenden Ansprüche 3-11, **dadurch gekennzeichnet, dass** die Vorsprünge (15) durch Pressen des Stahlblechs gebildet sind.

12. Verwendung eines Systems nach einem der vorhergehenden Ansprüche für ein kombiniertes Absturzsicherungssystem und Befestigungssystem.

13. Verwendung eines Befestigungssystems, das mindestens eine Basis (1) zur Montage auf einer Dachfläche beinhaltet, wobei die Basis (1) eine Anschlagplatte (2) zur Befestigung an der Dachfläche und eine erste Ankerstange (3) beinhaltet, die von der Oberseite der Anschlagplatte hervorsteht, wobei die Ankerstange (3) in einer Hülse (4) in der Anschlagplatte (2) montiert ist und mit Verankerungsmitteln (49, 55, 60, 65, 70, 75) verbunden ist, die in Abhängigkeit vom Verwendungszweck ausgestaltet sind, wobei eine zweite Ankerstange (11) ebenfalls in einer Hülse (4) in der Anschlagplatte (2) montiert ist, die von der Unterseite der Anschlagplatte nach unten ragt und mit Befestigungsmitteln (12, 24, 29, 31) versehen ist, sodass die zweite Ankerstange (11) in der tragenden Dachkonstruktion (23, 30, 32) unter der Dachfläche befestigt werden kann, wobei das Befestigungssystem auf mit Dachpappe oder Dachfolie bedeckten Dächern montiert ist, wobei das Dach eine Stützplatte (19) für eine Dachpappenabdeckung oder -membran (18), eine darunterliegende Isolierung (17) und eine tragende Dachkonstruktion (23) beinhaltet, wobei die Basis (1) in einen Dachpappen- oder Dachfolienanschluss integriert ist, wobei der Dachpappen- oder Dachfolienanschluss vorzugsweise eine untere Dachpappe (5) und eine obere Dachpappe (6) zur Befestigung an der Dachpappenabdeckung oder -membran (18) des Daches beinhaltet, für ein kombiniertes Absturzsicherungssystem und Befestigungssystem.

## Revendications

1. Système combiné de protection contre les chutes et de fixation pour le montage sur des toits recouverts de feutre ou de film de toiture et comportant au moins une base (1) pour le montage sur une surface de toit, le toit comportant une plaque de support (19) pour une couverture ou membrane en feutre de toiture (18), une isolation sous-jacente (17) et une construction de toit de support (23), dans lequel la base (1) est intégrée à un feutre de toiture ou un solin en film, le feutre de toiture ou le solin en film comportant de préférence un feutre de toiture inférieur (5) et un feutre de toiture supérieur (6) pour une fixation à la couverture ou membrane de feutre de toiture (18) du toit, la base (1) comportant une plaque de butée (2) pour une fixation à la surface de toit et une première tige d'ancrage (3) dépassant du côté supérieur de la plaque de butée, dans lequel la plaque de butée (2) est une plaque rectangulaire ayant des bords latéraux, dans lequel la tige d'ancrage (3) est montée dans une douille (4) dans la plaque de butée (2), et laquelle tige d'ancrage (3) est connectée à des moyens d'ancrage (49, 55, 60, 65, 70, 75) qui sont conçus en fonction de l'utilisation prévue, dans lequel la plaque de butée (2) est pourvue d'une forme tridimensionnelle car elle est pourvue de saillies s'étendant radialement (15) s'étendant depuis une partie centrale de la plaque rectangulaire et étant dirigée vers les coins de la plaque et le centre des longs côtés de la plaque, dans lequel les moyens d'ancrage comportent un raccord avec un œillet au niveau duquel peut être monté un fil qui fixe l'utilisateur directement au système combiné de protection contre les chutes et de fixation ou, en variante, l'œillet peut être utilisé pour un fil traversant (100) traversant également des œillets ou raccords correspondants d'autres bases faisant partie d'un système combiné de protection contre les chutes et de fixation, dans lequel une seconde tige d'ancrage (11) est également montée dans la douille (4) dans la plaque de butée (2),
faisant saillie vers le bas depuis le côté inférieur de la plaque de butée (2) et pourvue de moyens de fixation (12, 24, 29, 31) de sorte que la seconde tige d'ancrage (11) peut être fixée dans la construction de toit de support (23, 30, 32) sous la surface de toit.

2. Système combiné de protection contre les chutes et de fixation selon la revendication 1, **caractérisé en ce qu'**un tube de renforcement (13) qui est plus court que la seconde tige d'ancrage (11) est prévu autour de la seconde tige d'ancrage (11) .

3. Système combiné de protection contre les chutes et de fixation selon la revendication 1 ou 2, **caractérisé en ce que** la plaque de butée (2) est pourvue de saillies (15) depuis le côté supérieur de la plaque de butée afin de renforcer ainsi la résistance à la flexion de la plaque de butée.

4. Système combiné de protection contre les chutes et de fixation selon la revendication 2 ou les revendications 2 et 3, **caractérisé en ce que** la seconde tige d'ancrage (11) est pourvue d'un pas de vis interagissant avec un pas de vis dans la douille (4) de la plaque de butée, et **en ce que** la plaque de butée est serrée contre le tube de renforcement (13) de sorte qu'il y a une connexion mécanique de la plaque de butée (2) aux moyens de fixation (12, 24, 29, 31), qui sont fixés dans la construction de toit de support.

5. Système combiné de protection contre les chutes et de fixation selon la revendication 3 ou 4, **caractérisé en ce que** les saillies (15) sont prévues sous forme d'élévations allongées orientées radialement qui sont des parties comprimées ou moulées de la plaque de butée (2) et prévues en un nombre compris entre 6 et 12, de préférence 8.

6. Système combiné de protection contre les chutes et de fixation selon une quelconque revendication précédente, **caractérisé en ce que** les moyens d'ancrage (49, 55, 60, 65, 70, 75) comportent une monture de support (103, 109) qui est conçue pour monter un équipement (105, 108, 114) à disposer au-dessus de la couverture ou membrane en feutre de toiture (18), comme par exemple des panneaux solaires, des terrasses, des garde-corps, des tuyauteries, des unités de climatisation.

7. Système combiné de protection contre les chutes et de fixation selon une quelconque revendication précédente, **caractérisé en ce que** le moyen de fixation au niveau de la seconde tige d'ancrage (11) comporte une rondelle (14) destinée à venir en appui contre un côté supérieur (28, 43) de la construction de toit de support (23, 37).

8. Système combiné de protection contre les chutes et de fixation selon la revendication 7, **caractérisé en ce que** le moyen de fixation au niveau de la seconde tige d'ancrage (11) comporte une ancre d'inclinaison (24) destinée à venir en appui contre un côté inférieur (27) de la construction de toit de support (23) .

9. Système combiné de protection contre les chutes et de fixation selon une quelconque revendication précédente, **caractérisé en ce que** le système de fixation comporte un certain nombre de bases (1) pour le montage sur la surface de toit, et **en ce que** ces bases sont interconnectées avec des fils (100) et un système de rails (113) pour établir un système combiné de protection contre les chutes et un système de montage couvrant une zone souhaitée de la surface de toit.

10. Système combiné de protection contre les chutes et de fixation selon une quelconque revendication précédente, **caractérisé en ce que** la plaque de butée (2) est une tôle d'acier inoxydable résistant aux acides d'une épaisseur comprise entre 1,5 mm et 4 mm, de préférence 2 mm.

11. Système combiné de protection contre les chutes et de fixation selon l'une quelconque des revendications précédentes 3 à 11, **caractérisé en ce que** les saillies (15) sont formées en pressant la tôle d'acier.

12. Utilisation d'un système selon une quelconque revendication précédente pour un système combiné de protection contre les chutes et un système de montage.

13. Utilisation d'un système de fixation comportant au moins une base (1) pour le montage sur une surface de toit, la base (1) comportant une plaque de butée (2) pour la fixation à la surface de toit et une première tige d'ancrage (3) faisant saillie depuis le côté supérieur de la plaque de butée, dans lequel la tige d'ancrage (3) est montée dans une douille (4) dans la plaque de butée (2) et connectée à des moyens d'ancrage (49, 55, 60, 65, 70, 75) conçus en fonction de l'utilisation prévue, dans lequel une seconde tige d'ancrage (11) est également montée dans une douille (4) dans la plaque de butée (2), faisant saillie vers le bas depuis le côté inférieur de la plaque de butée et pourvue de moyens de fixation (12, 24, 29, 31) de sorte que la seconde tige d'ancrage (11) peut être fixée dans la construction de toit de support (23, 30, 32) sous la surface de toit, dans lequel le système de fixation est monté sur des toits recouverts de feutre ou de film de toiture, le toit comportant une plaque de support (19) pour une couverture ou membrane en feutre de toiture (18), une isolation sous-jacente (17) et une construction de toit de support (23), dans lequel la base (1) est intégrée à un feutre de toiture ou à un solin en film, le feutre de toiture ou le solin en film comportant de préférence un feutre de toiture inférieur (5) et un feutre de toiture supérieur (6) à fixer à la couverture ou membrane en feutre de toiture (18) du toit, pour un système combiné de protection contre les chutes et un système de montage.
